# DEMANDE DE BREVET EUROPEEN

(11) **EP 4 848 904 A1**
(43) Date de publication de la demande: **02.12.2026**
(21) Numéro de dépôt: 26181247.3
(22) Date de dépôt: 27.05.2026
(51) Int. Cl.: H05K 1/02

(54) **CARTE ÉLECTRONIQUE À INTERFÉRENCES ATTÉNUÉES**

(30) Priorité: 28.05.2025 FR 2505803
(71) Demandeur: SAGEMCOM BROADBAND SAS, 92270 Bois-Colombes (FR)
(72) Inventeur: TISNE, Alain, 92270 Bois Colombes (FR)
(74) Mandataire: Regimbeau

(57) **Abrégé**

La présente invention concerne une carte électronique **(1)** comprenant :
- une couche **(11)** délimitant un passage **(2)** s'étendant dans la carte électronique **(1),** la couche **(11)** présentant une surface électriquement conductrice **(12** ; **12')** présentant deux premiers bords **(21** ; **21')** et deux deuxièmes bords **(22** ; **22')** délimitant entre eux un orifice **(20** ; **20')** donnant accès au passage **(2)** et ayant :
une première dimension **(d1)** mesurée dans une première direction **(A)** comme une distance séparant les premiers bords **(21** ; **21'),** et
une deuxième dimension **(d2)** mesurée dans une deuxième direction **(B)** orthogonale à la première direction **(A)** comme une distance séparant les deuxièmes bords **(22** ; **22'),** la deuxième dimension **(d2)** étant supérieure à la première dimension **(d1),**

- un conducteur électrique **(3 ; 3')** s'étendant dans la première direction **(A)** en chevauchant au moins partiellement l'orifice **(20).**

## Description

### DOMAINE DE L'INVENTION

L'invention concerne de manière générale le domaine des cartes électroniques, plus particulièrement celui des cartes électroniques multicouche comprenant des vias traversant, notamment celles utilisées dans les équipements de communication à radiofréquences.

### ETAT DE LA TECHNIQUE

Les équipements de communications comme les passerelles domestiques (i.e. *home gateways* selon la terminologie anglo-saxonne), les routeurs, les décodeurs de télévision numérique (par exemple de type *Set Top-Box* selon la terminologie anglo-saxonne), mais aussi les objets connectés tels que des compteurs d'eau, d'électricité ou de gaz communicant et les téléphones mobiles peuvent embarquer un ou plusieurs systèmes radio fréquences utilisant par exemple les protocoles 2G, 3G, 4G, 5G, Bluetooth, WiFi, etc. Les composants de ces équipements sont montés sur au moins une carte électronique comprenant un circuit imprimé. Les antennes des systèmes radio sont généralement intégrées dans les équipements en étant soit imprimées sur le circuit imprimé (i.e. antennes imprimées), soit disposées sur une coque plastique externe (i.e. antennes internes), soit encore déportées du circuit imprimé par l'intermédiaire de câbles coaxiaux ou externes (i.e. antenne externe).

L'intégration dans un même équipement de circuits intégrés, de circuits de routage de signaux et d'antennes est rendue complexe à cause de la génération potentielle de rayonnements parasites que peuvent capter les antennes. On parle alors d'interférences électromagnétiques (« Electro-Magnetic Interferences », EMI dans la terminologie anglo-saxonne), qui peuvent réduire la portée effective de transmission radio des équipements de communications.

Pour les équipements de petite taille mais demandant une forte accessibilité à tous les systèmes radio, l'état de l'art consiste à blinder électromagnétiquement toute la carte électronique et de ne laisser apparentes que les antennes. Cette solution est par exemple adoptée dans le cas des téléphones mobiles. Cependant, cette approche est coûteuse si la carte électronique est de grande dimension. Les équipements de communications de taille intermédiaire, tels que les passerelles domestiques, décodeurs de télévision, compteurs d'eau ou d'énergie (e.g. électricité, gaz) utilisent des technologies de circuit imprimé classique avec des cartes électroniques comprenant généralement deux à six couches.

Ces cartes électroniques peuvent embarquer plusieurs fonctions électroniques (e.g. réception et/ou émission radio, microprocesseur et mémoires associées, etc) reliées entre elles par des bus de communications rapides avec parfois des changements de couches.

Chacune de ces fonctions peut nécessiter un blindage individuel, par exemple sous forme de ceintures et capots. Ces blindages de tailles variables sont complexes à fabriquer et à installer.

Pour relier deux plans d'alimentations ou plans de masse routés sur deux couches différentes, mais aussi de procéder au changement de couche pour les signaux électriques de commande et/ou de communications à travers les différentes couches de la carte, **il** est connu d'utiliser des trous métallisés, c'est-à-dire des orifices aux parois conductrices ou vias, en particulier des vias traversant toute l'épaisseur de la carte électronique. Par définition, un trou métallisé est un cylindre creux recouvert sur sa surface interne d'une couche métallique électriquement conductrice. Malheureusement, lors du passage d'une couche interne vers une autre couche interne, les extrémités externes des vias se comportent comme des petites lignes ouvertes (ou *stubs*) qui peuvent créer un rayonnement parasite.

Ce problème est encore accentué lorsque deux vias côte à côte sont réalisés, ce qui est fréquent pour router des signaux numériques rapides sous forme de paires différentielles. Une paire différentielle comprend deux pistes électriques à impédances contrôlées disposées côte à côte avec des signaux d'amplitude égale et de polarité opposée sur chaque piste.

Le passage d'au moins une piste à travers une ouverture se comporte comme une antenne à fente (« slot antenna » dans la terminologie anglo-saxonne).

Dans le cas d'une paire différentielle, le changement de couche d'une telle paire est réalisé par deux vias côte à côte, ce qui forme une ouverture oblongue dans la carte électronique.

Dans ce cas, l'ouverture dans l'épaisseur de la carte électronique est doublée par rapport à celle d'un via isolé, et cette ouverture oblongue est excitée par deux signaux, ce qui peut créer un rayonnement de puissance très supérieure à celle d'un seul via et donc générer bien plus d'interférences électromagnétiques.

Il existe donc un besoin de limiter les interférences électromagnétiques causées par les vias lorsqu'ils sont traversés par des signaux électriques, en particulier des signaux numériques rapides.

Par définition, un signal électrique rapide présente une largeur de spectre de plusieurs MHz à plusieurs GHz. Par exemple, les bus de communications numériques rapides, tels que PCle (*Peripheral Component Interconnect Express*), USB3 (*Universal Serial Bus*), DDR4 (*Double Data Rate*), HDMI (*High Definition Multimedia Interface*) ont des spectres s'étalant de 0 Hz à plusieurs GHz, typiquement 6, 7 ou 10 GHz.

### EXPOSE DE L'INVENTION

Un but de la présente invention est de réduire voire éliminer les interférences électromagnétiques générées par la présence passage traversant une carte électronique.

A cette fin, l'invention propose une carte électronique comprenant :
- une couche délimitant un passage s'étendant dans la carte électronique, la couche présentant une surface électriquement conductrice, la surface électriquement conductrice présentant deux premiers bords délimitant entre eux un orifice donnant accès au passage et deux deuxièmes bords délimitant entre eux l'orifice, l'orifice ayant :
   ∘ une première dimension mesurée dans une première direction comme une distance séparant les deux premiers bords,
   ∘ une deuxième dimension mesurée dans une deuxième direction orthogonale à la première direction comme une distance séparant les deux deuxièmes bords, la deuxième dimension étant supérieure à la première dimension,
- un conducteur électrique comprenant deux bornes reliées à la surface électriquement conductrice, le conducteur électrique s'étendant depuis l'une des bornes jusqu'à l'autre borne dans la première direction en chevauchant les deux premiers bords, en chevauchant au moins partiellement l'orifice.

La carte électronique selon l'invention est avantageusement complétée par les caractéristiques suivantes, prises isolément ou en l'une de leur combinaison techniquement possible :
- le conducteur électrique s'étend depuis l'une des bornes jusqu'à l'autre borne dans la première direction sans chevaucher les deux deuxièmes bords ;
- les deux bornes du conducteur électrique sont situées à distance des deux premiers bords, la carte électronique comprenant par ailleurs un isolant électrique propre à empêcher un courant électrique en provenance de l'une des bornes et acheminé par le conducteur électrique d'atteindre l'un ou l'autre des deux premiers bords avant d'atteindre l'autre borne ;
- le conducteur électrique est un dipôle passif ;
- le conducteur électrique est un condensateur, de préférence un condensateur céramique multicouche ;
- le conducteur électrique est une résistance ;
- le conducteur électrique est une inductance, par exemple une inductance bobinée ou une inductance imprimée ;
- le conducteur électrique a une impédance inférieure ou égale à 1 ohm ;
- la carte électronique comprend une autre surface électriquement conductrice qui est opposée à la surface électriquement conductrice, l'autre surface électriquement conductrice présentant deux autres premiers bords délimitant entre eux un autre orifice donnant également accès au passage et deux autres deuxièmes bords délimitant entre eux l'autre orifice, l'autre orifice ayant :
   ∘ une autre première dimension mesurée dans la première direction comme une distance séparant les deux autres premiers bords,
   ∘ une autre deuxième dimension mesurée dans la deuxième direction comme une distance séparant les deux autres deuxièmes bords, l'autre deuxième dimension étant supérieure à l'autre première dimension,
   la carte électronique comprenant en outre un autre conducteur électrique comprenant deux bornes reliées à l'autre surface électriquement conductrice, l'autre conducteur électrique s'étendant depuis l'une de ses bornes jusqu'à l'autre de ses bornes dans la première direction en chevauchant les deux autres premiers bords, en chevauchant au moins partiellement l'orifice.
- l'autre conducteur électrique s'étend dans la première direction sans chevaucher les deux autres deuxièmes bords.

L'invention concerne également un procédé de fabrication d'une carte électronique selon l'exposé ci-dessus, le procédé comprenant la liaison des bornes du conducteur électrique à la surface électriquement conductrice, de sorte que le conducteur électrique s'étende depuis l'une des bornes jusqu'à l'autre borne dans la première direction en chevauchant les deux premiers bords et partiellement l'orifice.

Enfin, l'invention concerne également un dispositif de communication comprenant une carte électronique selon l'exposé ci-dessus et au moins une antenne.

Le dispositif selon l'invention peut être un décodeur de télévision numérique, une passerelle domestique ou un compteur communicant.

La carte électronique selon l'invention résout le problème posé grâce au conducteur électrique et à sa position par rapport à l'orifice. En effet, un courant dit courant de masse ou contre-courant circulant dans la couche conductrice dans la première direction vers l'orifice ne contourne pas cet orifice en longeant les deux premiers bords, ce qui évite de générer un dipôle magnétique formé par deux champs magnétiques disjoints et opposés dans l'orifice entre les deux premiers bords. Un tel courant peut en effet traverser l'orifice en utilisant le conducteur électrique comme raccourci.

Le conducteur électrique peut être sélectionné parmi différents dipôles électriques très répandus et peu coûteux. De plus, son implantation sur une face externe de la carte électronique est aisée et peut être réalisée après ou lors de la production de celle-ci.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :
La figure 1 illustre une vue en trois dimensions d'un trou traversant d'une carte électronique selon un état de l'art antérieur à l'invention ;
La figure 2 illustre une vue schématique d'une carte électronique selon un mode de réalisation de l'invention ;
La figure 3 illustre une vue schématique d'une carte électronique selon un autre mode de réalisation ;
La figure 4 est un graphique représentant une efficacité d'émission de radiofréquences en décibel d'un orifice de la carte électronique en fonction d'une fréquence en gigahertz pour différentes valeurs d'impédance d'un conducteur électrique selon l'invention ;
La figure 5 est un graphique représentant une efficacité de couplage en décibel entre un orifice et une antenne de la carte électronique en fonction d'une fréquence en gigahertz, la première courbe correspondant à une carte électronique ne comprenant pas de conducteur électrique selon l'invention, la deuxième courbe correspondant à une carte électronique selon le mode de réalisation de la figure 2 et la troisième courbe correspondant à une carte électronique selon le mode de réalisation de la figure 3 ;
La figure 6 illustre une vue schématique d'une passerelle domestique comprenant une carte électronique selon un mode de réalisation de l'invention.

Sur l'ensemble des figures, les éléments similaires portent des références identiques.

### DESCRIPTION DETAILLEE DE L'INVENTION

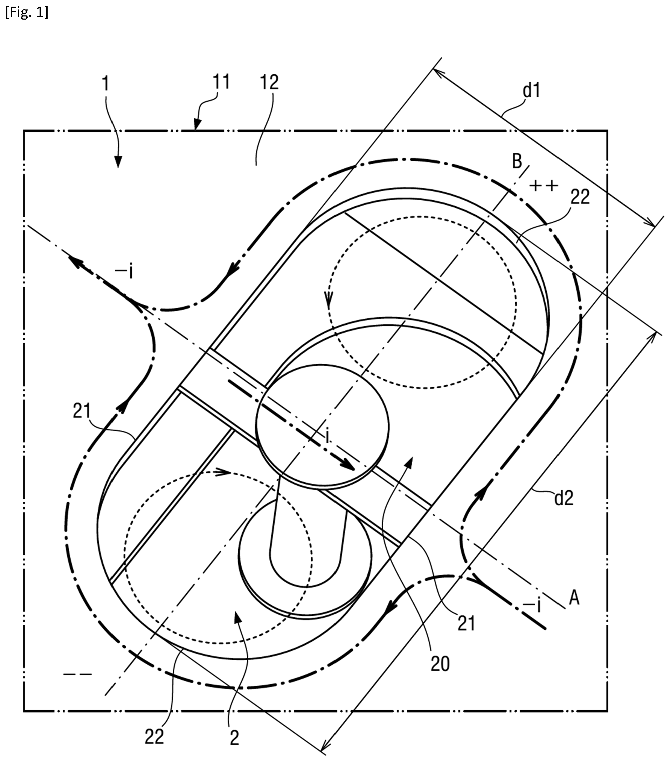

En référence à la figure 1, une carte électronique **1** comprend une couche **11** et un conducteur électrique **3.**

La couche **11** est une couche externe de la carte électronique **1.** A cet égard, la carte électronique peut comprendre un empilement de plusieurs couches, la couche **11** constituant une couche extrémale de l'empilement.

La couche **11** est de façon connue une couche de circuit imprimé ou de carte électronique commune dans l'état de la technique. La couche **11** délimite un passage **2** s'étendant dans la carte électronique **1.** De plus, la couche **11** présente une surface électriquement conductrice **12** qui présente deux premiers bords **21** et deux deuxièmes bords **22** délimitant entre eux un orifice **20** donnant accès au passage **2.**

Le passage **2** est par exemple formé par perçage dans la couche **11.** Les deux premiers bords **21** sont alors typiquement des segments de droites, tandis que les deux deuxièmes bords **22** sont typiquement des arcs de cercle. Le passage **2** est alors de même forme et s'étend dans la couche **11** perpendiculairement à la surface électriquement conductrice **12.**

La carte électronique **1** peut comprendre un via s'étendant dans le passage **2.** De façon connue en soi, un **via** est un élément de liaison électrique entre deux couches différentes de la carte électronique. Un via comprend un tube en métal, et est parfois appelé « trou métallisé » dans la littérature. Le passage **2** comprend donc une paroi intérieure électriquement conductrice configurée pour relier électriquement des couches de la carte électronique **1.** Les deux couches reliées électriquement par le via peuvent être différentes de la couche **11,** par exemple des couches internes de la carte électronique **1.** Alternativement, l'une des deux couches est la couche **11.**

La surface électriquement conductrice **12** est par exemple une surface de masse ou une surface d'alimentation de la carte électronique **1.**

L'orifice **20** présente ainsi dans un plan formé par la surface électriquement conductrice **12** une première dimension, mesurée dans une première direction **A** comme une distance **d1** séparant les deux premiers bords **21** et une deuxième dimension, mesurée dans une deuxième direction **B** orthogonale à la première direction **A** comme une distance **d2** séparant les deux deuxièmes bords **22.** La deuxième dimension **d2** est supérieure à la première dimension **d1,** de sorte que l'orifice **20** a une forme allongée dans le plan de la surface électriquement conductrice **12.** La première dimension **d1** constitue donc une largeur de l'orifice **20,** tandis que la deuxième dimension **d2** constitue une longueur de l'orifice **20.**

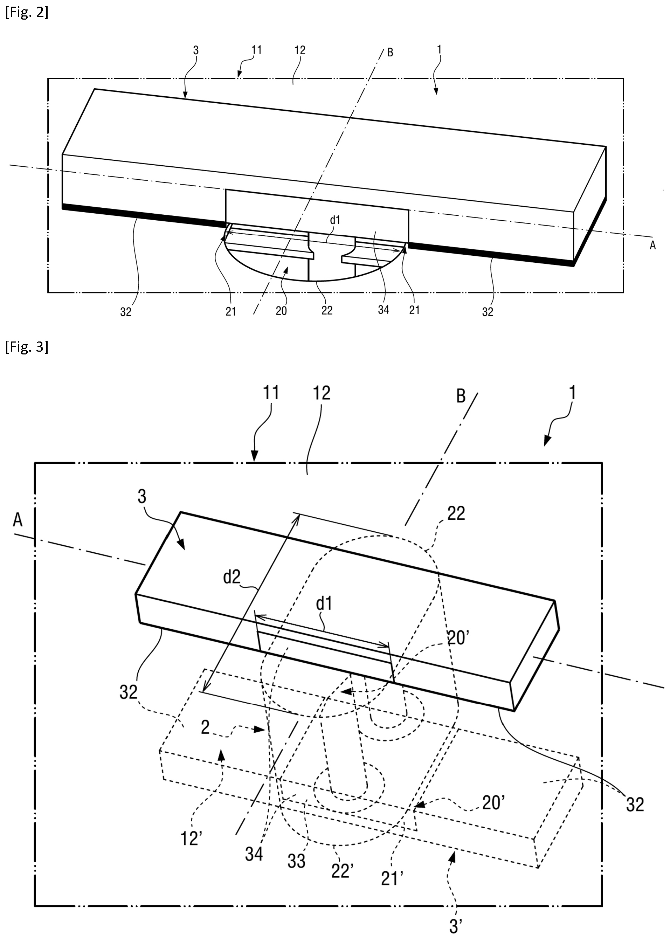

En référence à la figure 2, qui illustre un premier mode de réalisation de l'invention, le conducteur électrique **3** comprend deux bornes **32** reliées électriquement l'une à l'autre, le conducteur électrique **3** s'étendant donc entre ces deux bornes **32.** Les bornes **32** sont de préférence en métal et avantageusement recouvertes d'une couche d'étain ou d'argent pour être facilement reliées à une surface.

Chaque borne **32** est en effet reliée à la surface électriquement conductrice **12** en étant alignée dans la première direction **A,** de sorte que le conducteur électrique **3** s'étende depuis l'une des bornes **32** jusqu'à l'autre borne **32** en suivant la première direction **A.** Le conducteur électrique **3** chevauche les deux premiers bords **21** mais pas nécessairement les deux deuxièmes bords **22.** Autrement dit, le conducteur électrique **3** chevauche au moins partiellement l'orifice **20** en le traversant dans sa largeur. Avantageusement, une distance séparant les deux bornes **32,** mesurée dans la première direction **A** est supérieure à la distance séparant les deux deuxièmes bords **22,** mesurée dans la deuxième direction **B.**

Avantageusement, le conducteur électrique **3** s'étend depuis l'une des bornes **32** jusqu'à l'autre borne **32** dans la première direction **A** sans chevaucher les deux deuxième bords **22** ; **22'.** Le conducteur électrique **3** occupe ainsi un volume réduit et l'accès physique au passage **2** reste possible.

Les deux bornes **32** du conducteur électrique sont situées à distance des deux premiers bords **21** de sorte que les deux bornes **32** ne soient pas électriquement reliées au tube métallique du via. La carte électronique **1** comprend par ailleurs un isolant électrique. L'isolant électrique est configuré pour empêcher un courant électrique en provenance de l'une des bornes **32** et acheminé par le conducteur électrique **3** d'atteindre l'un ou l'autre des deux premiers bords **21** avant d'atteindre l'autre borne **32.** L'isolant électrique peut être un substrat isolant **34,** configuré pour chevaucher les deux premiers bords **21** en étant au contact de ceux-ci afin d'empêcher la formation de toute connexion électrique, en particulier entre les deux bornes **32** du conducteur électrique **3.**

Avantageusement, le substrat isolant **34** comprend de la céramique, par exemple de l'alumine Al₂O₃.

Le conducteur électrique **3** est un dipôle électrique, avantageusement un dipôle électrique passif, de type « composant monté en surface » (CMS, ou SMD : « Surface Mount Device » dans la terminologie anglo-saxonne).

Par exemple, le conducteur électrique **3** est une résistance.

De manière générale, l'impédance Z est une grandeur physique déterminée selon la formule suivante : Z=R+j.X, où R désigne la résistance électrique, X désigne la réactance, j désigne l'unité imaginaire des nombres complexes. Si la réactance est nulle (i.e. X=0), le dipôle électrique est purement résistif (i.e. Z=R). Si la réactance est positive (X>0), le dipôle électrique est inductif. Si la réactance est négative (X<0), le dipôle électrique est capacitif. Z, R, X sont des grandeurs physiques exprimées en ohms (Ω). La valeur d'impédance en ohms (Ω) correspond au module de l'impédance déterminé selon la formule suivante : $\left|Z\right| = \sqrt{{R}^{2} + {X}^{2}}$

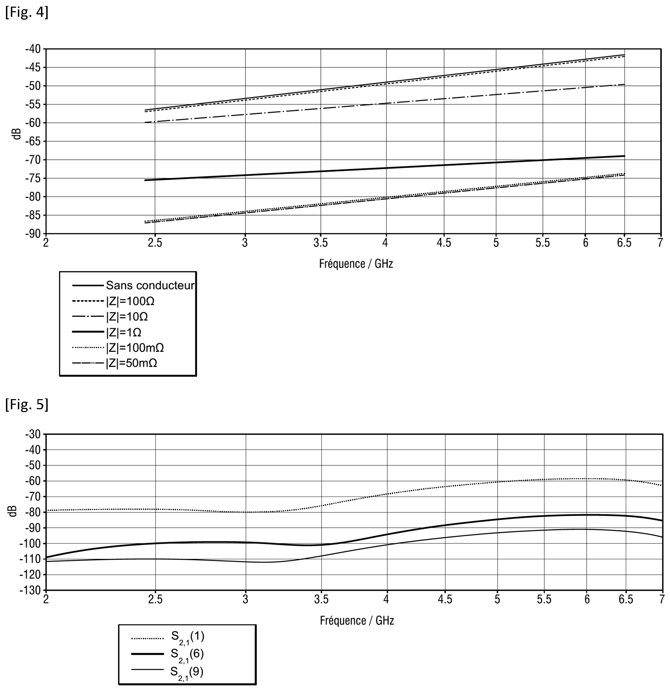

Comme montré figure 4, l'efficacité en décibel (dB) d'un rayonnement électromagnétique d'un orifice **20** varie pour différentes valeurs de résistance du conducteur électrique **3,** dans le cas où l'orifice **20** est un via alimenté en électricité (notamment, lorsqu'il est traversé par un signal numérique rapide). En comparaison avec un cas de référence où aucun conducteur électrique 3 n'est monté au-dessus de l'orifice **20** (première courbe en partant du haut sur la figure 4), une valeur d'impédance à 10 ohms (i.e. |*Z*| = 10Ω) permet d'atteindre une atténuation de quelques dB par rapport à la référence (troisième courbe sur la figure 4), une impédance inférieure à 1Ω permet une atténuation significative de plus d'une dizaine de dB, et pour une valeur plus faible comme 0,1Ω, l'atténuation est encore plus importante.

L'impédance (qui correspondant à la résistance si la réactance est nulle) du conducteur électrique **3** est donc de préférence la plus faible possible, c'est-à-dire inférieure à 1 ohm, préférentiellement de l'ordre du milliohm, encore plus préférentiellement comprise entre 10 et 50 mΩ.

Alternativement, le conducteur électrique **3** est un condensateur, par exemple un condensateur céramique multicouche. Avantageusement, le condensateur est sélectionné de sorte que la valeur C de sa capacité soit appropriée à la bande de fréquences d'une antenne que l'on souhaite préserver des interférences électromagnétiques, c'est-à-dire d'une antenne configurée pour recevoir des ondes radiofréquences dont la fréquence principale peut coïncider avec les fréquences du rayonnement parasite émis par le via et située à proximité de la carte électronique 1. En particulier, la capacité C est sélectionnée de sorte qu'une impédance maximale Z du condensateur soit très faible à ces fréquences (par exemple de l'ordre de quelques Ω, de préférence inférieure ou égale à 1 Ω) et présente une fréquence de résonnance bien supérieure à la fréquence maximum de fonctionnement de l'antenne. De manière connue, la capacité C du condensateur est déterminée en fonction de la fréquence f et de l'impédance Z selon la formule suivante : $C = \frac{1}{2 πfZ}$

Par exemple, pour une antenne Wi-Fi opérant à une fréquence égale à 2,4 GHz, le condensateur est configuré de sorte qu'à cette fréquence, il dispose d'une impédance maximale Z égale à 1 Ω. Dans ce cas, sa capacité C minimale est égale à 66 picofarads.

Alternativement, le conducteur électrique **3** est une inductance.

Par exemple, l'inductance est une inductance bobinée (i.e. *wired-wound* selon la terminologie anglo-saxonne) ou une inductance imprimée.

De manière connue, la valeur L de l'inductance est déterminée en fonction de la fréquence f et de l'impédance Z selon la formule suivante : $L = \frac{Z}{2 πf}$

De manière générale, le conducteur électrique **3** présente l'avantage qu'il peut être monté facilement sur n'importe quelle carte électronique en reliant, préférentiellement par soudure, les bornes **32** du conducteur électrique **3** à la surface électriquement conductrice **12,** de sorte que le conducteur électrique **3** s'étende depuis l'une des bornes **32** jusqu'à l'autre borne **32** dans la première direction **A** en chevauchant les deux premiers bords **21** et au moins partiellement l'orifice **20.**

Dans certaines variantes de réalisation (non illustrées), le conducteur électrique **3** chevauche les deux deuxièmes bords **22.**

Dans un deuxième mode de réalisation, illustré figure 3, le passage **2** traverse de part en part la carte électronique **1.** De façon symétrique à ce qui a été décrit ci-dessus, la couche **11** présente une autre surface électriquement conductrice **12'** qui présente deux autres premiers bords **21'** et deux autres deuxièmes bords **22'** délimitant entre eux un autre orifice **20'** donnant accès au passage **2.**

De façon similaire à l'orifice **20,** l'autre orifice **20'** présente dans le plan formé par l'autre surface électriquement conductrice **12'** une autre première dimension **d1,** mesurée dans la première direction **A** comme une distance séparant les deux autres premiers bords **21',** et une autre deuxième dimension **d2** mesurée dans la deuxième direction **B** comme une distance séparant les deux autres deuxièmes bords **22'.** L'autre deuxième dimension **d2** est supérieure à l'autre première dimension **d1,** de sorte que l'autre orifice **20'** a une forme allongée.

Un autre conducteur électrique **3',** conforme au conducteur électrique **3** du présent exposé, chevauche partiellement l'autre orifice **20'** en chevauchant les deux autres premiers bords **21'** mais pas nécessairement les deux autres deuxièmes bords 22'. Autrement dit, l'autre conducteur électrique **3'** chevauche partiellement l'orifice 20'.

Avantageusement, l'autre conducteur électrique **3'** s'étend depuis l'une des bornes 32 jusqu'à l'autre borne **32** dans la première direction **A** sans chevaucher les deux autres deuxième bords **22 ; 22'.** L'autre conducteur électrique **3'** occupe ainsi un volume réduit et l'accès physique au passage **2** reste possible.

Dans le cas où la carte électronique est multicouche, la couche **11** comprend une pluralité de sous-couches entre lesquelles des pistes conductrices sont prévues pour router des signaux électriques. Dans ce cas, les sous-couches externes de la couche **11** portent respectivement les deux conducteurs électriques **3, 3'** sur la surface électriquement conductrice **12** et sur l'autre surface électriquement conductrice **12',** comme décrit ci-dessus.

La figure 5 représente une magnitude de couplage **S_{2,1} (1), S_{2,1} (6)** et **S_{2,S} (9)** en dB entre un orifice **20** et une antenne de la carte électronique **1.** La première magnitude **S_{2,1} (1),** c'est-à-dire la première courbe en partant du haut correspond à une carte électronique de référence ne comprenant aucun conducteur électrique **3** selon le présent exposé, tandis que la deuxième courbe **S_{2,1} (9)** et la troisième courbe **S_{2,1} (6)** correspondent respectivement au cas où :
1) un orifice **20** est chevauché par un conducteur électrique **3** et un autre orifice **20'** n'est pas chevauché par un autre conducteur **3',**
2) un orifice **20** est chevauché par un conducteur électrique **3** et un autre orifice **20'** est chevauché par un autre conducteur **3',**
les conducteurs **3** et **3'** comprenant chacun une résistance de 0,1Ω.
Dans le cas 1), l'atténuation obtenue est d'environ 20 dB. Dans le cas 2), l'atténuation obtenue est plus importante d'environ 10 dB par rapport au cas 1). La présence d'un autre conducteur **3'** permet donc de réduire d'avantage le rayonnement parasite généré par le via et par conséquent permet de diminuer le risque de perturbation des antennes se situant à proximité de l'orifice **20,** c'est-à-dire du via rayonnant. Il s'ensuit que grâce à une telle atténuation, le positionnement des antennes dans un équipement de communications, tel qu'un décodeur de télévision numérique, une passerelle domestique, un compteur d'eau, d'électricité ou de gaz, un téléphone portable est moins contraint, ce qui facilite la conception de tels équipements, d'autant plus qu'ils sont soumis à des impératifs de compacité toujours plus contraignants.

La carte électronique **1** selon les modes de réalisation décrits ci-dessus réduit considérablement les interférences électromagnétiques et améliore donc la portée et la qualité de réception des antennes à proximité de la carte électronique **1,** montées sur la carte électronique **1** ou intégrées à elle. Plus précisément, grâce au conducteur électrique **3** chevauchant l'orifice **20,** un rayonnement électromagnétique parasite d'une carte électronique où le passage **2** est un via traversé par des pistes électriques à travers lesquelles transitent des signaux numériques rapides et dont l'orifice **20** ne comprend pas de conducteur électrique **3** est atténué dans un large domaine de fréquences, i.e. de 0 Hz jusqu'à plusieurs GHz. En effet, le conducteur électrique **3 a** pour effet de permettre le passage d'un contre-courant au-dessus de l'orifice **20** et de la piste qui le traverse. Ainsi, les courants circulant sur le pourtour de l'orifice **20,** qui sont générateurs du dipôle magnétique (i.e. rayonnement électromagnétique parasite) par effet de boucles de courant, sont fortement réduits.
La carte électronique **1** décrite trouve son application dans tout type de système, en particulier dans les dispositifs de communication comprenant une antenne, tel qu'un décodeur de télévision numérique ou une passerelle domestique.

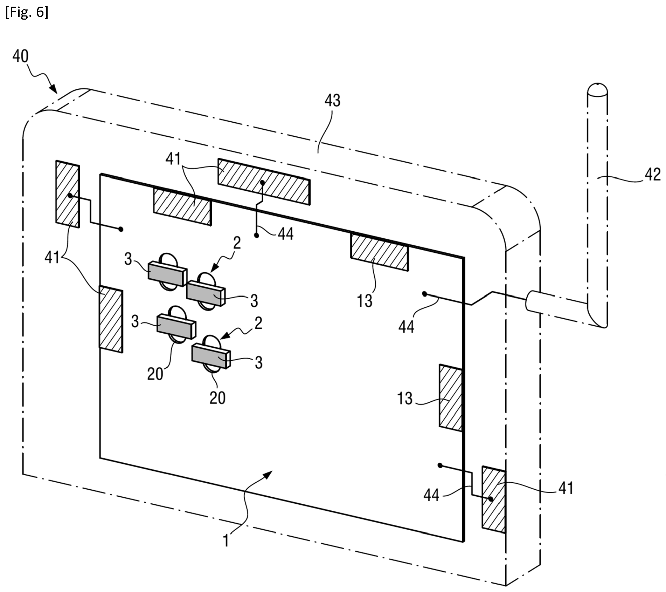

En référence à la figure 6, une telle passerelle domestique **40** comprend dans une coque **43** une carte électronique **1** selon l'un des modes de réalisation ci-dessus, en particulier une carte électronique **1** comprenant de deux à six couches **11** traversées par au moins quatre passages **2** correspondant à des vias traversants. De plus, la passerelle domestique **40** comprend une antenne interne **41** et/ou une antenne externe **42,** les termes interne et externe s'entendant par rapport à la coque **43.** L'antenne interne **41,** l'antenne externe **42** sont respectivement reliées à la carte électronique **1** par un câble coaxial **44.** En outre, la carte électronique **1** comprend une antenne imprimée **13.** La carte électronique **1** comprend une interface de communication configurée pour commander et interfacer l'antenne interne **41,** l'antenne externe **42** et l'antenne imprimée **13,** de sorte à communiquer par voie radio (par exemple selon les protocoles Wi-Fi ou Bluetooth) avec d'autres équipements (par exemple des enceintes sans fil, une télécommande ou un terminal mobile d'un utilisateur).

Comme décrit précédemment, les orifices **20** des passages **2** sont chevauchés par des conducteurs **3,** afin d'atténuer toute interférence électromagnétique générée par les antennes à fente formées par les passages **2.** Ainsi, il est possible de placer à n'importe quelle position, dans la passerelle domestique **40,** l'antenne interne **41,** l'antenne externe **42** et l'antenne imprimée **13** sans qu'elles soient susceptibles d'être perturbées par des interférences électromagnétiques.

Ceci permet de rendre la passerelle domestique **40** plus performante en termes de réception radio, dans la mesure où ses antennes ne sont plus perturbées par la présence de trous traversants, en particulier lorsqu'ils sont traversés par des signaux numériques rapides, tout en réduisant son coût de production, puisque la pose de blindages conventionnels n'est pas nécessaire. En effet, la soudure de simples conducteurs électriques en surface est une opération simple à réaliser et qui évite une désensibilisation des récepteurs radiofréquence, ce qui a pour avantage d'optimiser la portée effective de la transmission radiofréquence entre la passerelle domestique et les équipements associés, tels que des enceintes sans fil (e.g. *Wireless Surround Speaker).*

## Revendications

1. Carte électronique **(1)** comprenant :
- une couche **(11)** délimitant un passage **(2)** s'étendant dans la carte électronique **(1),** la couche **(11)** présentant une surface électriquement conductrice **(12 ; 12'),** la surface électriquement conductrice **(12 ; 12')** présentant deux premiers bords **(21** ; **21')** délimitant entre eux un orifice **(20 ; 20')** donnant accès au passage **(2)** et deux deuxièmes bords **(22 ; 22')** délimitant entre eux l'orifice **(20 ; 20'),** l'orifice **(20 ; 20')** ayant :
∘ une première dimension **(d1)** mesurée dans une première direction **(A)** comme une distance séparant les deux premiers bords **(21** ; **21'),**
∘ une deuxième dimension **(d2)** mesurée dans une deuxième direction **(B)** orthogonale à la première direction **(A)** comme une distance séparant les deux deuxièmes bords **(22 ; 22'),** la deuxième dimension **(d2)** étant supérieure à la première dimension **(d1),**
- un conducteur électrique **(3 ; 3')** comprenant deux bornes **(32)** reliées à la surface électriquement conductrice **(12 ; 12'),** le conducteur électrique **(3 ; 3')** s'étendant depuis l'une des bornes **(32)** jusqu'à l'autre borne **(32)** dans la première direction **(A)** en chevauchant les deux premiers bords **(21** ; **21'),** en chevauchant au moins partiellement l'orifice **(20),** dans lequel les deux bornes **(32)** du conducteur électrique **(3 ; 3')** sont situées à distance des deux premiers bords **(21** ; **21'),** la carte électronique **(1)** comprenant par ailleurs un isolant électrique **(34)** propre à empêcher un courant électrique en provenance de l'une des bornes **(32)** et acheminé par le conducteur électrique **(3 ; 3')** d'atteindre l'un ou l'autre des deux premiers bords **(21** ; **21')** avant d'atteindre l'autre borne **(32).**

2. Carte électronique **(1)** selon la revendication 1, dans lequel le conducteur électrique **(3 ; 3')** s'étendant depuis l'une des bornes **(32)** jusqu'à l'autre borne **(32)** dans la première direction **(A)** sans chevaucher les deux deuxième bords **(22 ; 22').**

3. Carte électronique **(1)** selon l'une des revendications 1 à 2, dans laquelle le conducteur électrique **(3 ; 3')** est un dipôle passif.

4. Carte électronique **(1)** selon l'une des revendications 1 à 3, dans laquelle le conducteur électrique **(3 ; 3')** est un condensateur, de préférence un condensateur céramique multicouche.

5. Carte électronique selon l'une des revendications 1 à 3 dans laquelle le conducteur électrique **(3 ; 3') est** une résistance.

6. Carte électronique **(1)** selon l'une des revendications 1 à 3, dans laquelle le conducteur électrique **(3 ; 3')** est une inductance, par exemple une inductance bobinée ou une inductance imprimée.

7. Carte électronique **(1)** selon l'une des revendications 1 à 6, dans laquelle le conducteur électrique **(3 ; 3')** a une impédance inférieure ou égale à 1 ohm.

8. Carte électronique **(1)** selon l'une des revendications 1 à 7, comprenant en outre
- une autre surface électriquement conductrice **(12 ; 12')** qui est opposée à la surface électriquement conductrice **(12 ; 12'),** l'autre surface électriquement conductrice **(12 ; 12')** présentant deux autres premiers bords **(21 ; 21')** délimitant entre eux un autre orifice **(20 ; 20')** donnant également accès au passage **(2)** et deux autres deuxièmes bords **(22 ; 22')** délimitant entre eux l'autre orifice **(20 ; 20'),** l'autre orifice **(20 ; 20')** ayant :
∘ une autre première dimension **(d1)** mesurée dans la première direction **(A)** comme une distance séparant les deux autres premiers bords (21 ; **21'),**
∘ une autre deuxième dimension **(d2)** mesurée dans la deuxième direction **(B)** comme une distance séparant les deux autres deuxièmes bords **(22 ; 22'),** l'autre deuxième dimension **(d2)** étant supérieure à l'autre première dimension **(d1)**
- un autre conducteur électrique **(3 ; 3')** comprenant deux bornes **(32)** reliées à l'autre surface électriquement conductrice, l'autre conducteur électrique **(3 ; 3')** s'étendant depuis l'une de ses bornes **(32)** jusqu'à l'autre de ses bornes **(32)** dans la première direction **(A)** en chevauchant les deux autres premiers bords **(21** ; **21'),** en chevauchant au moins partiellement l'orifice **(20, 20').**

9. Carte électronique selon la revendication précédente, dans lequel l'autre conducteur électrique **(3 ; 3')** s'étend dans la première direction **(A)** sans chevaucher les deux autres deuxièmes bords **(22 ; 22').**

10. Procédé de fabrication d'une carte électronique **(1)** selon l'une des revendications 1 à 9, comprenant relier les bornes **(32)** du conducteur électrique **(3 ; 3')** à la surface électriquement conductrice **(12 ; 12'),** de sorte que le conducteur électrique **(3 ; 3')** s'étende depuis l'une des bornes **(32)** jusqu'à l'autre borne **(32)** dans la première direction **(A)** en chevauchant les deux premiers bords **(21** ; **21')** et partiellement l'orifice **(20 ; 20').**

11. Dispositif de communication comprenant une carte électronique **(1)** selon l'une des revendications 1 à 9 et au moins une antenne **(41, 42).**

12. Dispositif selon la revendication 11, le dispositif étant un décodeur de télévision numérique.

13. Dispositif selon la revendication 11, le dispositif étant une passerelle domestique **(40).**

14. Dispositif selon la revendication 11, le dispositif étant un compteur communicant.
